# EUROPEAN PATENT APPLICATION

(11) **EP 4 496 009 A1**
(43) Date of publication of application: **22.01.2025**
(21) Application number: 23774597.1
(22) Date of filing: 10.03.2023
(51) Int. Cl.: H01L 29/82, H10B 61/00

(54) **METHOD FOR MANUFACTURING HALL ELEMENT, AND MAGNETIC MEMORY ELEMENT**

(30) Priority: 24.03.2022 JP 2022048131
(71) Applicant: KANAGAWA INSTITUTE OF INDUSTRIAL SCIENCE AND TECHNOLOGY, Ebina-shi Kanagawa 243-0435 (JP); Sumitomo Chemical Company, Limited, Tokyo 103-6020 (JP)
(72) Inventor: AZUMA, Masaki, Ebina-shi, Kanagawa 243-0435 (JP); SHIGEMATSU, Kei, Ebina-shi, Kanagawa 243-0435 (JP); LEE, Koomok, Ebina-shi, Kanagawa 243-0435 (JP)
(74) Representative: Meissner Bolte Nürnberg
(86) International application number: PCT/JP2023/009333
(87) International publication number: WO 2023/181998

(57) **Abstract**

A method of manufacturing a Hall element 18 includes: forming a perovskite-type magnetic material layer 14 on a substrate 12 having a perovskite structure and composed of a compound having a lattice constant of 3.90-3.97 Å in pseudocubic notation; forming an insulator layer 16 containing SrTiO₃ on the perovskite-type magnetic material layer 14; and forming a Hall element 18 containing InSb, GaAs, InAs or a solid solution thereof on the insulator layer 16.

## Description

### TECHNICAL FIELD

The present invention relates to a method for manufacturing a Hall element and a magnetic memory element.

### BACKGROUND ART

Conventionally, InSb, GaAs, or InAs compounds are used as materials of a Hall element used to read information in a magnetic memory. An InSb element is manufactured by, for example, depositing an InSb thin film on one surface of a mica substrate and forming an electrode and a protective film on the mica substrate (see, for example, Patent Literature 1).

### RELATED-ART LITERATURE

### PATENT LITERATURE

Patent Literature 1: JPH6-232479

### SUMMARY OF INVENTION

### TECHNICAL PROBLEM

When a Hall element is used to read information written in a magnetic memory, it is necessary to manufacture a Hall element suited to read the information written in the magnetic memory.

The present invention addresses the issue described above, and a purpose thereof is to provide a technology for manufacturing a Hall element suited to read information written in a magnetic memory.

### SOLUTION TO PROBLEM

A method of manufacturing a Hall element according to an embodiment of the present invention includes: forming a perovskite-type magnetic material layer on a substrate having a perovskite structure and composed of a compound having a lattice constant of 3.90-3.97 Å in pseudocubic notation; forming an insulator layer containing SrTiO₃ on the perovskite-type magnetic material layer; and forming a Hall element containing InSb on the insulator layer.

Another embodiment of the present invention relates to a magnetic memory element. The magnetic memory element includes: a substrate having a perovskite structure and composed of a compound having a lattice constant of 3.90-3.97 Å in pseudocubic notation; a perovskite-type magnetic material layer disposed on the substrate; an insulator layer disposed on the perovskite-type magnetic material layer and containing SrTiO₃; and a Hall element disposed on the insulator layer and containing InSb.

### ADVANTAGEOUS EFFECTS OF INVENTION

According to the present invention, it is possible to provide a technology for manufacturing a Hall element suited to read information written in a magnetic memory.

### BRIEF DESCRIPTION OF DRAWINGS

[Fig. 1] Figs. 1A-1D are sectional views showing an example of a process for manufacturing a Hall element according to an embodiment.
[Fig. 2] Figs. 2 is a schematic diagram showing a configuration of an exemplary magnetic memory element according to the embodiment.
[Fig. 3] Fig. 3 shows X-ray diffraction measurement results of the embodiment and the comparative example.
[Fig. 4] Fig. 4 shows Hall effect measurement results of the Hall element of the embodiment.
[Fig. 5] Fig. 5 shows Hall effect measurement results of the Hall element of the embodiment.

### DESCRIPTION OF EMBODIMENTS

Hereinafter, the invention will be described based on preferred embodiments with reference to drawings. The embodiments do not limit the scope of the invention but exemplify the invention. Not all of the features and the combinations thereof described in the embodiments are necessarily essential to the invention. Identical or like constituting elements, members, processes shown in the drawings are represented by identical symbols, and a duplicate description will be omitted as appropriate. The scales and shapes of the parts shown in the figures are defined for convenience's sake to make the explanation easy and shall not be interpreted limitatively unless otherwise specified.

### (Method for manufacturing a Hall element)

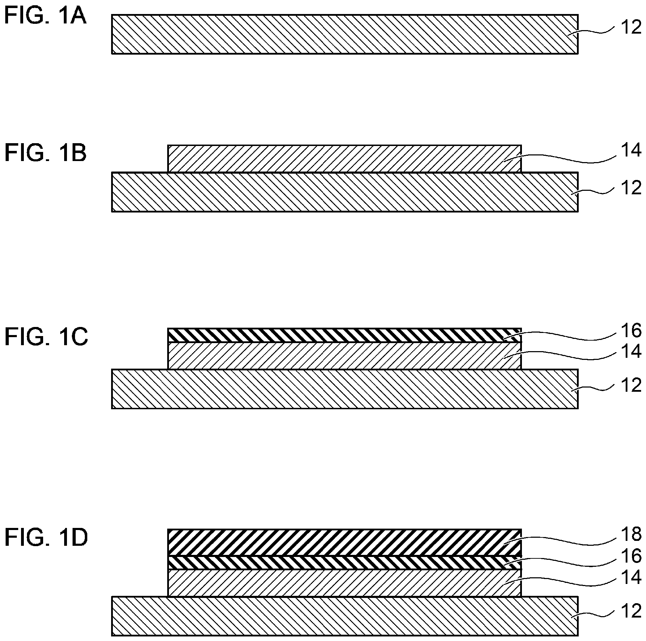

Figs. 1A-1D are sectional views showing an example of a process for manufacturing a Hall element according to an embodiment.

In the manufacturing method according to the embodiment, a substrate 12 is first prepared as shown in Fig. 1A. The substrate 12 has a perovskite structure and is composed of a compound having a lattice constant of 3.90-3.97 Å in pseudocubic notation. Specific examples of the substrate 12 include a 110 oriented GdScO₃ substrate, a 110 oriented DyScO₃ substrate, a 110 oriented SrTiO₃ substrate, a 111 oriented SrTiO₃ substrate, and a 001 oriented SrTiO₃ substrate.

Next, as shown in Fig. 1B, a perovskite-type magnetic material layer (hereinafter simply referred to as a magnetic material layer) 14 is formed on the substrate 12. Examples of the perovskite-type magnetic material constituting the magnetic material layer 14 include La₂NiMnO₆, CeCu₃Mn₄O₁₂, La_{0.7}Sr_{0.3}MnO₃, etc.
Preferably, the magnetic material layer 14 is composed of a compound represented by the following formula (1).

BiFe₁₋ₓAₓO₃ ... (1)

Referring to formula (1), A denotes Co or Mn, and x satisfies 0.05≤x<0.25. When x is 0.05 or more, the magnetic material layer 14 can exhibit ferromagnetism and ferroelectricity at room temperature. When x is less than 0.25, changes in the crystal structure of the magnetic material layer 14 can be suppressed.

Next, as shown in Fig. 1C, an insulator layer 16 is formed on the magnetic material layer 14. The insulator layer 16 contains SrTiO₃. Thereafter, as shown in Fig. 1D, a Hall element 18 containing InSb, GaAs, InAs or a solid solution thereof is formed on the insulator layer 16. By forming the Hall element 18 via the insulator layer 16 on the magnetic material layer 14 in this way, it is possible to prevent a reaction between the magnetic material constituting the magnetic material layer 14 and InSb, GaAs, or InAs constituting the Hall element 18. Therefore, the Hall element 18 can read information written by reversing the magnetic field of the magnetic material layer 14 as an electrical signal. In this way, a Hall element 18 suited to read information written in a magnetic memory can be manufactured.

The magnetic material layer 14, the insulator layer 16, and the Hall element 18 may not be formed by the method described above and can be formed by a method known to those skilled in the art, such as physical vapor deposition method (PVD method) and chemical vapor deposition method (CVD method). Specific examples of PVD method include pulsed laser deposition (PLD) method and electron beam deposition method. Specific examples of CVD method include metal-organic (MO) CVD method and mist CVD method.

The shapes of the substrate 12, the magnetic material layer 14, the insulator layer 16, and the Hall element 18 are not limited to those shown, and a suitable shape can be selected according to the application.

### (Magnetic memory element)

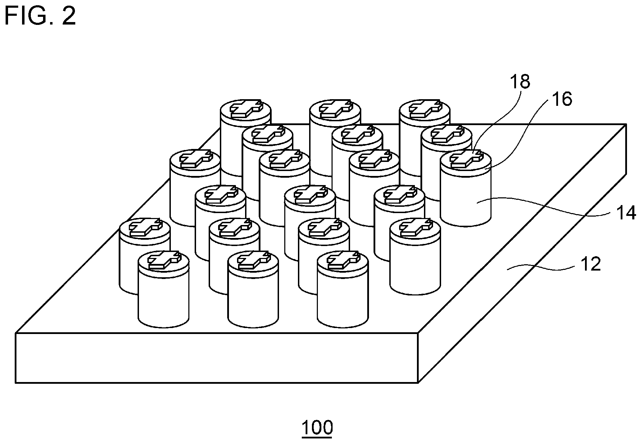

Fig. 2 is a schematic diagram showing a configuration of an exemplary magnetic memory element according to the embodiment. A magnetic memory element 100 includes a substrate 12 having a perovskite structure and composed of a compound having a lattice constant of 3.90-3.97 Å in pseudocubic notation, a perovskite-type magnetic material layer 14 disposed on the substrate 12, an insulator layer 16 disposed on the magnetic material layer 14, and a Hall element 18 disposed on the insulator layer 16.

The substrate 12 has a perovskite structure and is composed of a compound having a lattice constant of 3.90-3.97 Å in pseudocubic notation. Forming the magnetic material layer 14 on the substrate 12 composed of such a compound makes it possible to manifest magnetization intrinsic to the magnetic material layer 14 itself and to reverse the magnetization of the magnetic material layer 14 by applying a magnetic field or an electric field. Specific examples of the substrate 12 include a 110 oriented GdScO₃ substrate, a 110 oriented DyScO₃ substrate, a 110 oriented SrTiO₃ substrate, a 111 oriented SrTiO₃ substrate, and a 001 oriented SrTiO₃ substrate. The thickness of the substrate 12 is not particularly limited, but from the viewpoint of thin film synthesis and ease of handling, 300 µm-1000 µm is preferable, and 400 µm-600 µm is more preferable.

Preferably, the perovskite-type magnetic material layer 14 is composed of a compound represented by the following formula (1).

BiFe₁₋ₓAₓO₃ ... (1)

Referring to formula (1), A denotes Co or Mn, and x satisfies 0.05≤x<0.25. When x is 0.05 or more, the magnetic material layer 14 can exhibit ferromagnetism and ferroelectricity at room temperature. When x is less than 0.25, changes in the crystal structure of the magnetic material layer 14 can be suppressed. The magnitude of spontaneous magnetization of the magnetic material layer 14 at room temperature is about 1 emu/cm³-10 emu/cm³, and the magnitude of spontaneous polarization is about 50-150 µC/cm². The magnetization direction of the magnetic material layer 14 composed of this compound can be reversed by an electric field generated by applying a voltage. This allows information to be written in the magnetic material layer 14. Further, the written information can be read by detecting the reversed magnetization by the Hall element 18.

The thickness of the magnetic material layer 14 is, for example, 30 nm-1000 nm. Given such a thickness of the magnetic material layer 14, an electric field can be reliably applied to the magnetic material layer 14, and the reliability of the device can be improved. From the viewpoint of lattice distortion, the thickness of the magnetic material layer 14 is preferably 50 nm-400 nm.

The insulator layer 16 contains SrTiO₃. The thickness of the insulator layer 16 is, for example, 1 nm-50 nm. From the viewpoint of suppressing a reaction with the magnetic material layer 14 and suppressing shielding of the magnetic field from the magnetic material layer 14 by the insulator layer 16 itself, the thickness of the insulator layer 16 is preferably 2 nm-30 nm and, more preferably, 4 nm-10 nm.

The Hall element 18 contains InSb, GaAs, InAs or a solid solution thereof. The shape of the Hall element 18 shown in Fig. 1 is not particularly limited and may be another shape such as a cross shape as shown in Fig. 2 and a cylindrical shape. By forming the Hall element 18 via the insulator layer 16 on the magnetic material layer 14 as shown in Fig. 2, it is possible to prevent a reaction between the magnetic material constituting the magnetic material layer 14 and InSb, GaAs, or InAs constituting the Hall element 18. This makes it possible to detect reversal of the magnetic field of the magnetic material layer 14 as an electrical signal.

### Embodiment

Hereinafter, an embodiment of the present invention will be described, but the embodiment merely represents an example for suitably explaining the present invention and should not be construed as limiting the invention.

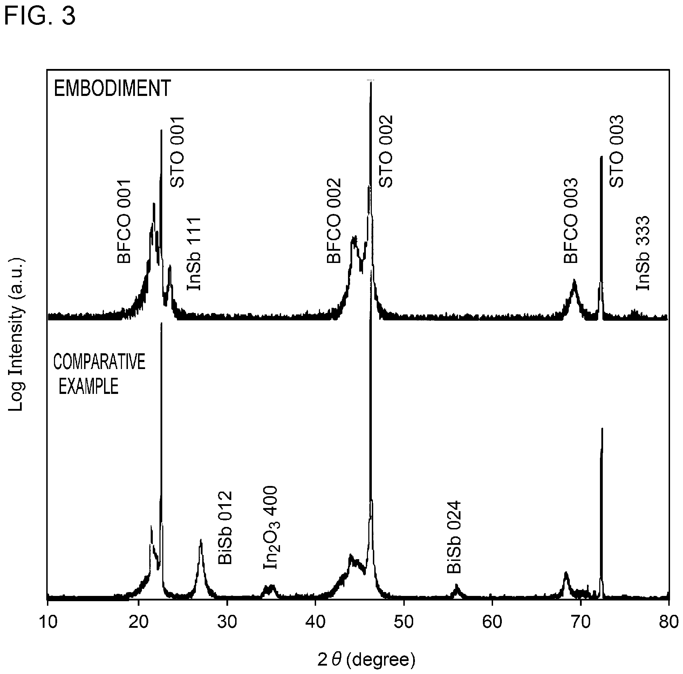

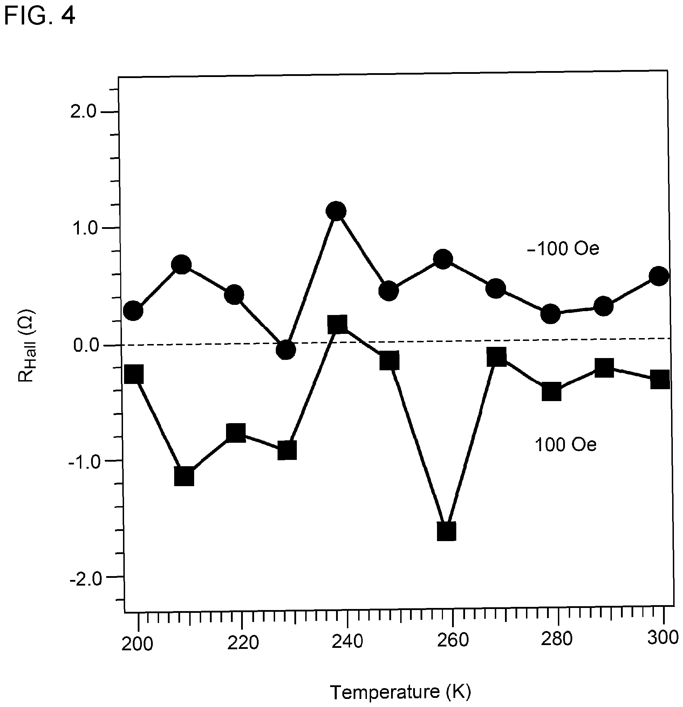

The Hall element according to the embodiment was manufactured by pulsed laser deposition (PLD) method. A BiFe₁₋ₓCoₓO₃(BFCO) layer (thickness 60 nm) was produced on a SrTiO₃(001) substrate under the condition shown in Table 1. Then a SrTiO₃ (STO) insulator layer (thickness 6.7 nm) was produced on the BFCO layer, and an InSb layer (150 nm) was produced on the insulator layer. Further, a Hall element was manufactured as a comparative example in the same manner as in the embodiment except that an InSb thin film was produced on a BFCO thin film without producing an STO insulator layer. The crystallinity was evaluated using X-ray diffraction (XRD) (SmartLab from Rigaku). The Hall effect was measured using a physical property measurement system (from Quantum Design, Inc. in the United States). Fig. 3 shows X-ray diffraction measurement results of the embodiment and the comparative example. Fig. 4 shows Hall effect measurement results of the Hall element of the embodiment.

**Table 1**

| Layer | Substrate temperature ( °C) | Oxygen partial pressure (Pa) | Laser energy density (J/cm²) | Laser repetition frequency (Hz) |
|---|---|---|---|---|
| BFCO | 660 | 15 | 1.0 | 5 |
| STO | 660 | 15 | 1.0 | 1 |
| InSb | 250 | 1.3×10⁻³ | 0.5-0.6 | 20 |

As shown in Fig. 3, a reaction between Bi of the BFCO layer and In of the InSb layer was observed in the comparative example. In the embodiment, on the other hand, each layer could be produced properly without a reaction between Bi and In.

It can be seen from Fig. 4 that the Hall voltage in the InSb layer is reversed when the external magnetic field is +100 Oe and when it is -100 Oe and that the Hall element of the embodiment can detect reversal of the external magnetic field as an electrical signal.

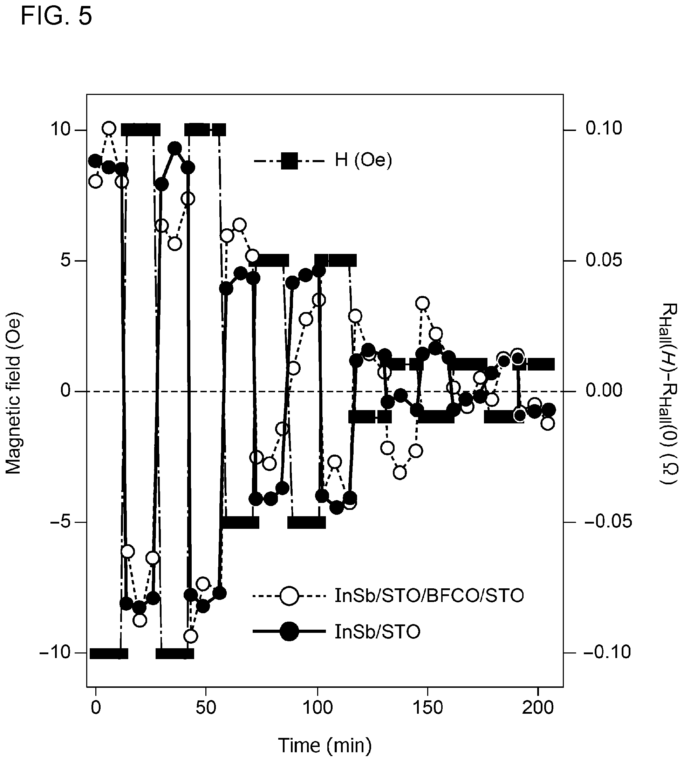

Further, the Hall effect of the Hall element according to the embodiment exhibited when the magnetic field is reversed multiple times at room temperature was measured using a physical property measurement system (from Quantum Design, Inc. in the United States). The results are shown in Fig. 5. It can be seen from Fig. 5 that when the magnetic field is reversed, the sign of the Hall resistance changes, and that the Hall element functions as a sensor capable of detecting a magnetic field of 1 Oe.

The embodiments of the present invention are not limited to those described above and appropriate combinations or replacements of the features of the embodiments are also encompassed by the present invention. The embodiments may be modified by way of combinations, rearranging of the processing sequence, various design changes, etc., based on the knowledge of a skilled person, and the embodiment modified as such are also within the scope of the present invention.

### INDUSTRIAL APPLICABILITY

The present invention can be used in a method for manufacturing a Hall element and a magnetic memory element.

### REFERENCE SIGNS LIST

12 substrate, 14 perovskite-type magnetic material layer, 16 insulator layer, 18 Hall element, 100 magnetic memory element

## Claims

1. A method of manufacturing a Hall element, comprising:
forming a perovskite-type magnetic material layer on a substrate having a perovskite structure and composed of a compound having a lattice constant of 3.90-3.97 Å in pseudocubic notation;
forming an insulator layer containing SrTiO₃ on the perovskite-type magnetic material layer; and
forming a Hall element containing InSb, GaAs, InAs or a solid solution thereof on the insulator layer.

2. A magnetic memory element comprising:
a substrate having a perovskite structure and composed of a compound having a lattice constant of 3.90-3.97 Å in pseudocubic notation;
a perovskite-type magnetic material layer disposed on the substrate;
an insulator layer disposed on the perovskite-type magnetic material layer and containing SrTiO₃; and
a Hall element disposed on the insulator layer and containing InSb, GaAs, InAs or a solid solution thereof.

3. The magnetic memory element according to claim 2,
wherein the substrate is selected from the group consisting of: a 110 oriented GdScO₃ substrate, a 110 oriented DyScO₃ substrate, a 110 oriented SrTiO₃ substrate, a 111 oriented SrTiO₃ substrate, and a 001 oriented SrTiO₃ substrate.

4. The magnetic memory element according to claim 2, wherein the perovskite-type magnetic material layer is a thin film composed of a compound represented by a formula (1) below and having a thickness of 50 nm-1000 nm,
BiFe₁₋ₓAₓO₃ ... (1)
[in formula (1), A denotes Co or Mn, and x satisfies 0.05≤x<0.25].
